# EUROPEAN PATENT APPLICATION

(11) **EP 4 776 809 A1**
(43) Date of publication of application: **15.07.2026**
(21) Application number: 24938331.6
(22) Date of filing: 20.05.2024
(51) Int. Cl.: H10K 59/35, H10K 59/12, H10K 50/18, H10K 101/30

(54) **DISPLAY PANEL AND DISPLAY DEVICE**

(30) Priority: 14.05.2024 CN 202410598782
(71) Applicant: Wuhan China Star Optoelectronics Semiconductor Display Technology Co., Ltd., Wuhan, Hubei 430079 (CN)
(72) Inventor: LI, Lintao, Wuhan, Hubei 430079 (CN); ZHAO, Juewen, Wuhan, Hubei 430079 (CN)
(74) Representative: Zhu, Puxing
(86) International application number: PCT/CN2024/094227
(87) International publication number: WO 2025/236309

(57) **Abstract**

The present application provides a display panel and a display device. The display panel includes a first electron blocking layer and a first light-emitting layer those are stacked. The first light-emitting layer includes a first blue light unit, a first green light unit, and a first red light unit, and the first electron blocking layer includes a first electron blocking part corresponding to the first blue light unit, a second electron blocking part corresponding to the first green light unit, and a third electron blocking part corresponding to the first red light unit. The first electron blocking part, the second electron blocking part, and the third electron blocking part are arranged into an integrated structure.

## Description

### TECHNICAL FIELD

The present application relates to the field of display technologies, and in particular, to a display panel and a display device.

### BACKGROUND

Organic light-emitting diode (full English name: Organic Light-Emitting Diode, abbreviation: OLED) display panels, compared to liquid crystal display panels, have advantages of thinner and lighter, better display effect, higher resolution, wider color gamut, and the ability to achieve flexible display, so the OLED display panels have developed rapidly in recent years, have become the preferred display panel type for small-size applications, and have gradually expanded to medium and large-size applications.

The field of medium and large-sized OLED displays has higher requirements for the stability of the display, which increases an application demand for tandem OLED display devices having great advantages in the display life, and major display manufacturers have also invested resources in technology and product development.

Researchers of the application found that, in related arts, tandem OLED devices have complex structures, high material costs, and complex manufacturing processes, resulting in high manufacturing costs for display panels. Therefore, how to streamline a structure of the tandem device in a targeted manner and reduce the manufacturing costs of the display panel are urgent technical problems that those skilled in the art need to solve.

### SUMMARY

The present application provides a display panel and a display device, which can effectively solve the technical problems of complex structure and high manufacturing costs of the display panel.

In a first aspect, the present application provides a display panel. The display panel includes:
a substrate;
a first electrode layer, disposed on one side of the substrate;
a first electron blocking layer, disposed on one side of the first electrode layer facing away from the substrate;
a first light-emitting layer, disposed on one side of the first electron blocking layer facing away from the substrate;
a charge generation layer, disposed on one side of the first light-emitting layer facing away from the substrate;
a second light-emitting layer, disposed on one side of the charge generation layer facing away from the substrate; and
a second electrode layer, disposed on one side of the second light-emitting layer facing away from the substrate,
wherein the first light-emitting layer includes a first blue light unit, a first green light unit, and a first red light unit, and the first electron blocking layer includes a first electron blocking part corresponding to the first blue light unit, a second electron blocking part corresponding to the first green light unit, and a third electron blocking part corresponding to the first red light unit; and
in the first electron blocking layer, the first electron blocking part, the second electron blocking part, and third electron blocking part are arranged into an integrated structure.

In a second aspect, the present application provides a display device. The display device includes a housing and a display panel according to any one of the above. The housing has an accommodating space, and the display panel is disposed in the accommodating space.

### BENEFICIAL EFFECTS

The present application provides a display panel and a display device. The display panel includes a substrate, a first electrode layer, a first electron blocking layer, a first light-emitting layer, a charge generation layer, a second light-emitting layer, a second light-emitting layer, and a second electrode layer. The first electrode layer is provided on one side of the substrate, the first electron blocking layer is provided on one side of the first electrode layer facing away from the substrate, the first light-emitting layer is provided on one side of the first electron blocking layer facing away from the substrate, the charge generation layer is disposed on one side of the first light-emitting layer facing away from the substrate, the second light-emitting layer is disposed on one side of the charge generation layer facing away from the substrate, and the second electrode layer is disposed on one side of the second light-emitting layer facing away from the substrate. The first light-emitting layer includes a first blue light unit, a first green light unit, and a first red light unit. The first electron blocking layer includes a first electron blocking part, a second electron blocking part, and a third electron blocking part. The first electron blocking part corresponds to the first blue light unit, the second electron blocking part corresponds to the first green light unit, and the third electron blocking part corresponds to the first red light unit. In the first electron blocking layer, the first electron blocking part, the second electron blocking part, and the third electron blocking part are arranged into an integrated structure. The display panel provided by the present application can effectively solve the technical problems of complex structure and high manufacturing costs of display panels.

### DESCRIPTION OF DRAWINGS

In order to more clearly illustrate the technical solutions in the embodiments of the present application, the drawings needed to be used in the description of the embodiments will be briefly introduced below. Obviously, the drawings in the following description are only some embodiments of the present application. For those skilled in the art, other drawings may also be obtained based on these drawings without exerting creative efforts.
FIG. 1 is a schematic structural diagram of a display panel provided in Embodiment 1 of the present application.
FIG. 2 is a schematic structural diagram of a display panel provided in Embodiment 2 of the present application.

### Explanation of reference symbols:

substrate, 10; first electrode layer, 20; first hole injection layer, 30; first hole transport layer, 40; first electron blocking layer, 50; first electron blocking part, 51; second electron blocking part, 52; third electron blocking part, 53; first light-emitting layer, 60; first blue light unit, 61; first green light unit, 62; first red light unit, 63; first hole blocking layer, 70; first electron transport layer, 80; charge generation layer, 90; first-type charge generation layer, 91; second-type charge generation layer, 92; second hole transport layer, 100; second electron blocking layer, 110; fourth electron blocking part, 111; fifth electron blocking part, 112; sixth electron blocking part, 113; second light-emitting layer, 120; second blue light unit, 121; second green light unit, 122; second red light unit, 123; second hole blocking layer, 130; second electron transport layer, 140; second electron injection layer, 150; second electrode layer, 160; capping layer, 170; third electron blocking layer, 180; seventh electron blocking part, 181; eighth electron blocking part, 182.

### EMBODIMENTS OF THE INVENTION

The technical solutions in embodiments of the present application will be clearly and completely described below with reference to the accompanying drawings in the embodiments of the present application. Obviously, the described embodiments are only some of the embodiments of the present application, rather than all of the embodiments. Based on the embodiments in the present application, all other embodiments obtained by those skilled in the art without making creative efforts fall within the protection scope of the present application. In addition, it should be understood that specific embodiments described here are only used to illustrate and explain the invention, and are not intended to limit the invention. In the present application, unless otherwise specified, orientational terms such as "upper" and "lower" usually refer to the upper and lower positions of the device in actual use or working conditions, specifically orientations in the drawings. The terms "inside" and "outside" refer to the outline of the device.

The following disclosure provides many different embodiments or examples for implementing the various structures of the present application. To simplify the disclosure of the present application, the components and arrangements of specific examples are described below. Of course, they are merely examples and are not intended to limit the application. Furthermore, the present application may repeat reference numbers and/or reference letters in different examples, such repetition being for the purposes of simplicity and clarity and does not by itself indicate a relationship between the various embodiments and/or arrangements discussed. In addition, the present application provides examples of various specific processes and materials, but one of ordinary skill in the art will recognize the application of other processes and/or the use of other materials. Detailed descriptions are provided below. It should be noted that the order of description of the following embodiments is not intended to limit the preferred order of the embodiments.

In a first aspect, the present application provides a display panel. The display panel includes:
a substrate;
a first electrode layer, disposed on one side of the substrate;
a first electron blocking layer, disposed on one side of the first electrode layer facing away from the substrate;
a first light-emitting layer, disposed on one side of the first electron blocking layer facing away from the substrate;
a charge generation layer, disposed on one side of the first light-emitting layer facing away from the substrate;
a second light-emitting layer, disposed on one side of the charge generation layer facing away from the substrate; and
a second electrode layer, disposed on one side of the second light-emitting layer facing away from the substrate,
wherein the first light-emitting layer includes a first blue light unit, a first green light unit, and a first red light unit, and the first electron blocking layer includes a first electron blocking part corresponding to the first blue light unit, a second electron blocking part corresponding to the first green light unit, and a third electron blocking part corresponding to the first red light unit; and
in the first electron blocking layer, the first electron blocking part, the second electron blocking part, and third electron blocking part are arranged into an integrated structure.

Optionally, the second light-emitting layer includes a second blue light unit, the display panel further includes a second electron blocking layer, the second electron blocking layer includes a fourth electron blocking part corresponding to the second blue light unit, and the fourth electron blocking part is made of a same material as the first electron blocking part.

Optionally, both the first blue light unit and the second blue light unit includes fluorescent materials.

Optionally, the second light-emitting layer further includes a second green light unit, the second electron blocking layer includes a fifth electron blocking part corresponding to the second green light unit, a HOMO energy level of the second electron blocking part is greater than a HOMO energy level of the fifth electron blocking part, and a LUMO energy level of the second electron blocking part is less than a LUMO energy level of the fifth electron blocking part.

Optionally, a thickness of the second electron blocking part is same with a thickness of the first electron blocking part, and a thickness of the fifth electron blocking part is 5-7 times a thickness of the fourth electron blocking part.

Optionally, the second light-emitting layer further includes a second red light unit, the second electron blocking layer includes a sixth electron blocking part corresponding to the second red light unit, a HOMO energy level of the third electron blocking part is greater than a HOMO energy level of the sixth electron blocking part, and a LUMO energy level of the third electron blocking part is less than a LUMO energy level of the sixth electron blocking part.

Optionally, a thickness of the third electron blocking part is same with a thickness of the first electron blocking part, and a thickness of the sixth electron blocking part is 15-17 times a thickness of the fourth electron blocking part.

Optionally, the charge generation layer includes a first-type charge generation layer and a second-type charge generation layer, and the second-type charge generation layer is disposed on one side of the first-type charge generation layer facing away from the first light-emitting layer; the first-type charge generation layer includes an electron mobility enhancement material, and a doping ratio of the electron mobility enhancement material ranges from 5% to 15%; and the second-type charge generation layer includes a hole mobility enhancement material, and a doping ratio of the hole mobility enhancement material ranges from 1% to 10%.

Optionally, the fourth electron blocking part, the fifth electron blocking part, and the sixth electron blocking part are spaced apart from each other.

Optionally, the second light-emitting layer further includes a second green light unit and a second red light unit, the second electron blocking layer further includes a fifth electron blocking part corresponding to the second green light unit and a sixth electron blocking part corresponding to the second red light unit; and in the second electron blocking layer, the fourth electron blocking part, the fifth electron blocking part, and the sixth electron blocking part are arranged into an integrated structure; the display panel further includes a third electron blocking layer disposed between the second light-emitting layer and the second electron blocking layer, the third electron blocking layer includes a seventh electron blocking part corresponding to the second green light unit and an eighth electron blocking part corresponding to the second red light unit, and the seventh electron blocking part and the eighth electron blocking part are spaced apart from each other.

Optionally, a surface of the second blue light unit close to the substrate is in direct contact with a surface of the second electron blocking layer facing away from the substrate.

In a second aspect, the present application provides a display device. The display device includes a housing and a display panel according to any one of the above. The housing has an accommodating space, and the display panel is disposed in the accommodating space.

The technical solutions of the present application are introduced below with reference to specific embodiments.

### Embodiment 1

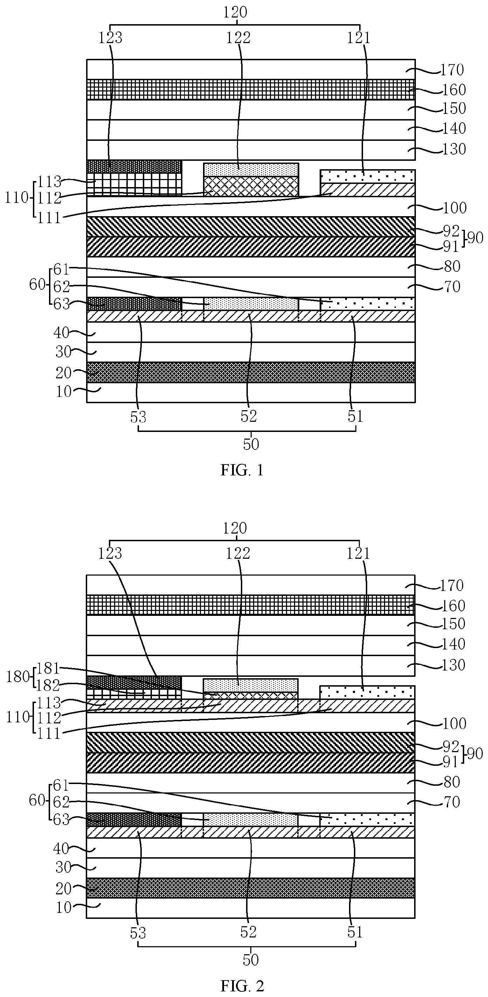

FIG. 1 is a schematic structural diagram of a display panel provided in Embodiment 1 of the present application. Referring to FIG. 1, in a first aspect, Embodiment I of the present application provides a display panel. The display panel includes a substrate 10, a first electrode layer 20, a first electron blocking layer 50, a first light-emitting layer 60, a charge generation layer 90, a second light-emitting layer 120, and a second electrode layer 160. The first electrode layer 20 is provided on one side of the substrate 10. The first electron blocking layer 50 is provided on one side of the first electrode layer 20 facing away from the substrate 10. The first light-emitting layer 60 is disposed on one side of the first electron blocking layer 50 facing away from the substrate 10. The charge generation layer 90 is disposed on one side of the first light-emitting layer. 60 facing away from the substrate 10. The second light-emitting layer 120 is disposed on one side of the charge generation layer 90 facing away from the substrate 10. The second electrode layer 160 is disposed on one side of the second light-emitting layer 120 facing away from the substrate 10. The first light-emitting layer 60 includes a first blue light unit 61, a first green light unit 62, and a first red light unit 63. The first electron blocking layer 50 includes a first electron blocking part 51, a second electron blocking part 52, and a third electron blocking part 53. The first electron blocking part 51 corresponds to the first blue light unit 61, and the second electron blocking part 52 corresponds to the first green light unit 62, and the third electron blocking part 53 corresponds to the first red light unit 63. In the first electron blocking layer 50, the first electron blocking part 51, the second electron blocking part 52, and the third electron blocking part 53 are arranged into an integrated structure.

In the display panel provided by the embodiments of the present application, both the first light-emitting layer 60 disposed between the first electrode layer 20 and the charge generation layer 90 and the second light-emitting layer 120 disposed between the charge generation layer 90 and the second electrode layers 160 have a light-emitting function and together realize a display function by serving as two light-emitting layers in a tandem OLED device.

In the display panel provided by the embodiments of the present application, the first electron blocking layer 50 can block electrons from entering the first electrode layer 20 so that more of them remain in the first light-emitting layer 60, thereby increasing the probability of recombination of electrons and holes, and thereby improving a luminous efficiency of the display panel and extending a service life of the display panel. Specifically, the first electron blocking part 51 corresponding to the first blue light unit 61 enables more electrons to remain in the first blue light unit 61, the second electron blocking part 52 corresponding to the first green light unit 62 enables more electrons to remain in the first green light unit 62, and the third electron blocking part 53 corresponding to the first red light unit 63 enables more electrons to remain in the first red light unit 63.

In the display panel provided by the embodiments of the present application, since the first electron blocking part 51, the second electron blocking part 52, and the third electron blocking part 53 in the first electron blocking layer 50 are arranged into the integrated structure, therefore, the first electron blocking layer 50 including the first electron blocking part 51, the second electron blocking part 52, and the third electron blocking part 53 has an entire surface. Compared with a patterned electron blocking layer in related arts, the integrated structure may be manufactured by saving two masks and two photomasks, thereby simplifying process steps and reducing the production and manufacturing costs. Moreover, since the first electron blocking part 51, the second electron blocking part 52, and the third electron blocking part 53 are arranged into the integrated structure, therefore, they can be made of the same material by the same process, thereby reducing types of materials and reducing material costs.

In some embodiments of the present application, the second light-emitting layer 120 includes a second blue light unit 121 corresponding to the first blue light unit 61. The display panel further includes a second electron blocking layer 110. The second electron blocking layer 110 includes a fourth electron blocking part 111 corresponding to the second blue light unit 121. The fourth electron blocking part 111 is made of the same material as the first electron blocking part 51.

In the display panel provided by the embodiments of the present application, a function of the second electron blocking layer 110 is similar to a function of the first electron blocking layer 50, but the difference is that the second electron blocking layer 110 can block electrons from entering the second electrode layer 160 so that more of them remain in the second light-emitting layer 120, thereby increasing the probability of recombination of electrons and holes, and thereby improving the luminous efficiency of the display panel and extending the service life of the display panel. Specifically, the fourth electron blocking part 111 corresponding to the second blue light unit 121 enables more electrons to remain in the second blue light unit 121 to improve a luminous efficiency of the second blue light unit 121 and extend a service life of the second blue light unit 121.

In the display panel provided by the embodiments of the present application, the fourth electron blocking part 111 is made of the same material as the first electron blocking part 51. That is, the fourth electron blocking part 111 may be made of the material forming the first electron blocking layer 50, thereby further reducing the material costs. More importantly, among the light units of different colors, the blue light units (including the first blue light unit 61 and the second blue light unit 121) are more sensitive to the performance of the electron blocking parts. Because the fourth electron blocking part 111 is arranged corresponding to the second blue light unit 121 whose emitting color is blue, that the material of the fourth electron blocking part 111 is used to form the first electron blocking part 51, the second electron blocking part 52, and the third electron blocking part 53 of the first electron blocking layer 50 can maximize the luminous efficiency and service life of the first blue light unit 61 in the first light-emitting layer 60 on the basis of simplifying the process and reducing material costs, thereby improving a display quality of the display panel.

In some embodiments of the present application, both the first blue light unit 61 and the second blue light unit 121 include fluorescent materials.

In the display panel provided by the embodiments of the present application, since the first blue light unit 61 and the second blue light unit 121 both include fluorescent materials, and compared with other light-emitting materials such as phosphorescent materials, the fluorescent materials have higher requirements for the performance of the electron blocking parts, which results in the blue light unit being more sensitive to the electron blocking layer. Furthermore, in a material selection of the first electron blocking layer 50, it is necessary to make materials of the first electron blocking part 51, the second electron blocking part 52, and the third electron blocking part 53 in the first electron blocking layer 50 are the same as the fourth electron blocking part 111.

In some embodiments of the present application, the second light-emitting layer 120 further includes a second green light unit 122. The second electron blocking layer 110 includes a fifth electron blocking part 112, and the fifth electron blocking part 112 corresponds to the second green light unit 122.

In the display panel provided by the embodiments of the present application, the fifth electron blocking part 112 corresponding to the second green light unit 122 enables more electrons to remain in the second green light unit 122.

In some embodiments of the present application, a HOMO energy level of the second electron blocking part 52 is greater than a HOMO energy level of the fifth electron blocking part 112, and a LUMO energy level of the second electron blocking part 52 is less than a LUMO energy level of the fifth electron blocking part 112.

The HOMO energy level refers to the highest occupied molecular orbital (full English name: Highest Occupied Molecular Orbital) energy level, the LUMO energy level refers to the lowest unoccupied molecular orbital (English full name: Lowest Unoccupied Molecular Orbital) energy level.

In the display panel provided by the embodiments of the present application, since the HOMO energy level of the second electron blocking part 52 is greater than the HOMO energy level of the fifth electron blocking part 112, and the LUMO energy level of the second electron blocking part 52 is less than the LUMO energy level of the fifth electron blocking part 112, therefore, an electron blocking performance of the second electron blocking part 52 is better than an electron blocking performance of the fifth electron blocking part 112, so that more electrons can be better remained in the first green light unit 62.

In some embodiments of the present application, a thickness of the second electron blocking part 52 is the same with a thickness of the first electron blocking part 51, and a thickness of the fifth electron blocking part 112 is 5-7 times a thickness of the fourth electron blocking part 111.

In the display panel provided by the embodiments of the present application, the materials and processes of the second electron blocking part 52 and the first electron blocking part 51 are the same. Correspondingly, the second electron blocking part 52 and the first electron blocking part 51 can be manufactured in the same process conditions to enable the same thickness.

In the display panel provided by the embodiments of the present application, a luminous efficiency of the second green light unit 122 is greater than a luminous efficiency of the first green light unit 62, which has a greater impact on the display effect of the display panel. A relative position of a microcavity of the second green light unit 122 directly affects the luminous efficiency of the second green light unit 122. In the related arts, a thickness of the second electron blocking part 52 corresponding to the first green light unit 62 is different from a thickness of the first electron blocking part 51 corresponding to the first blue light unit 61, such as the thickness of the second electron blocking part 52 being greater than the thickness of the first electron blocking part 51. Therefore, when the thickness of the second electron blocking part 52 is the same with the thickness of the first electron blocking part 51, it is equivalent to thinning the second electron blocking part 52, which in turn affects the relative position of the microcavity of the second electron blocking part 52, causing the microcavity of the second green light unit 122 to sink a certain distance, so that a light output of the second green light unit 122 cannot be maintained in a microcavity enhanced state, thereby reducing the display effect of the display panel. In the related arts, a thickness of the fifth electron blocking part 112 is 2-4 times a thickness of the fourth electron blocking part 111.

The display panel provided by the embodiments of the present application makes the thickness of the fifth electron blocking part 112 being 5-7 times the thickness of the fourth electron blocking part 111 to thicken the fifth electron blocking part 112. That is, by thickening the fifth electron blocking part 112, the relative position of the microcavity of the second green light unit 122 is adjusted, so that on the condition that the second electron blocking part 52 has the same thickness as the first electron blocking part 51, the light output of the second green light unit 122 is maintained in the microcavity enhanced state, thereby improving the display effect of the display panel.

In some embodiments of the present application, the second light-emitting layer 120 further includes a second red light unit 123. The second electron blocking layer 110 includes a sixth electron blocking part 113, and the sixth electron blocking part 113 corresponds to the second red light unit 123.

In the display panel provided by the embodiments of the present application, the sixth electron blocking part 113 corresponding to the second red light unit 123 enables more electrons to remain in the second red light unit 123.

In some embodiments of the present application, a HOMO energy level of the third electron blocking part 53 is greater than a HOMO energy level of the sixth electron blocking part 113, and a LUMO energy level of the third electron blocking part 53 is less than a LUMO energy level of the sixth electron blocking part 113.

In the display panel provided by the embodiments of the present application, since the HOMO energy level of the third electron blocking part 53 is greater than the HOMO energy level of the sixth electron blocking part 113, and the LUMO energy level of the third electron blocking part 53 is less than the LUMO energy level of the sixth electron blocking part 113, therefore, an electron blocking performance of the third electron blocking part 53 is better than an electron blocking performance of the sixth electron blocking part 113. Therefore, more electrons can be better remained in the first red light unit 63.

In some embodiments of the present application, a thickness of the third electron blocking part 53 is the same with a thickness of the first electron blocking part 51, and a thickness of the sixth electron blocking part 113 is 15-17 times a thickness of the fourth electron blocking part 111.

In the display panel provided by the embodiments of the present application, the third electron blocking part 53 and the first electron blocking part 51 can be made of the same material by the same process. Correspondingly, the third electron blocking part 53 and the first electron blocking part 51 manufactured in the same process conditions to enable the same thickness.

In the display panel provided by the embodiments of the present application, a luminous efficiency of the second red light unit 123 is greater than a luminous efficiency of the first red light unit 63, which has a greater impact on the display effect of the display panel. A relative position of a microcavity of the second red light unit 123 directly affects the luminous efficiency of the second red light unit 123. In the related arts, a thickness of the third electron blocking part 53 corresponding to the first red light unit 63 is different from a thickness of the first electron blocking part 51 corresponding to the first blue light unit 61, such as the thickness of the third electron blocking part 53 being greater than the thickness of the first electron blocking part 51. Therefore, when the thickness of the third electron blocking part 53 is the same with the thickness of the first electron blocking part 51, it is equivalent to thinning the third electron blocking part 53, which in turn affects the relative position of the microcavity of the second electron blocking part 53, causing the microcavity of the second red light unit 123 to sink a certain distance, so that a light output of the second red light unit 123 cannot be maintained in a microcavity enhanced state, thereby reducing the display effect of the display panel. In the related arts, a thickness of the sixth electron blocking part 113 is 10-12 times a thickness of the fourth electron blocking part 111.

The display panel provided by the embodiments of the present application makes the thickness of the sixth electron blocking part 113 being 15-17 times the thickness of the fourth electron blocking part 111 to thicken the sixth electron blocking part 113. That is, by thickening the sixth electron blocking part 113, the relative position of the microcavity of the second red light unit 123 is adjusted, so that on the condition that the third electron blocking part 53 has the same thickness as the thickness of the first electron blocking part 51, the light output of the second red light unit 123 is maintained in the microcavity enhanced state, thereby improving the display effect of the display panel.

In some embodiments of the present application, the charge generation layer 90 includes a first-type charge generation layer 91 and a second-type charge generation layer 92. The second-type charge generation layer 92 is disposed on one side of the first-type charge generation layer 91 facing away from the first light-emitting layer 60. The first-type charge generation layer 91 includes an electron mobility enhancement material, and a doping ratio of the electron mobility enhancement material ranges from 5% to 15%. The second-type charge generation layer 92 includes a hole mobility enhancement material, and a doping ratio of the hole mobility enhancement material ranges from 1% to 10%.

In the display panel provided by the embodiments of the present application, when the thickness of the first electron blocking part 51, the thickness of the second electron blocking part 52, and the thickness of the third electron blocking part 53 are the same, it is equivalent to thinning the second electron blocking part 52 and the third electron blocking part 53, which shortens paths for holes to enter the first green light unit 62 and the first red light unit 63, thereby affecting an equilibrium state of charge carriers (including electrons and holes) of the first green light unit 62 and an equilibrium state of charge carriers (including electrons and holes) of the first red light unit 63, reducing the luminous efficiency of the first green light unit 62 and the luminous efficiency of the first red light unit 63, and shortening a service life of the first green light unit 62 and a service life of the first red light unit 63.

In the present application, by making the doping ratio of the electron mobility enhancement material in the first-type charge generation layer 91 ranging from 5% to 15%, an electron mobility of the first green light unit 62 and an electron mobility of the first red light unit 63 are increased, thereby improving the equilibrium state of charge carriers in the first green light unit 62 and the equilibrium state of charge carriers in the first red light unit 63, improving the luminous efficiency of the first green light unit 62 and the luminous efficiency of the first red light unit 63, extending the service life of the first green light unit 62 and the service life of the first red light unit 63, and improving a smear problem in a low grayscale state of the display panel.

Specifically, the first-type charge generation layer 91 is an N-type charge generation layer 90.

In some embodiments of the present application, an electron mobility of the first-type charge generation layer 91 is greater than or equal to 10⁻³ cm²/Vs, and the electron mobility enhancement material includes metals, such as Yb, Li, Cs, Mg, etc.

In the display panel provided by the embodiments of the present application, when the thickness of the fifth electron blocking part 112 is 5-7 times the thickness of the fourth electron blocking part 111, and the thickness of the sixth electron blocking part 113 is 15-17 times the thickness of the fourth electron blocking part 111, it is equivalent to thickening the fifth electron blocking part 112 and the sixth electron blocking part 113, which prolongs the paths for holes to enter the second green light unit 122 and the second red light unit 123, thereby affecting an equilibrium state of charge carriers (including electrons and holes) of the second green light unit 122 and thereby affecting an equilibrium state of charge carriers (including electrons and holes) of the second red light unit 123, reducing a luminous efficiency of the second green light unit 122 and a luminous efficiency of the second red light unit 123, and shortening a service life of the second green light unit 122 and a service life of the second red light unit 123.

In the present application, by making the doping ratio of the hole mobility enhancement material in the second-type charge generation layer 92 ranging from 1% to 10%, the electron mobility of the first green light unit 62 and the electron mobility of the first red light unit 63 are reduced, thereby improving the equilibrium state of charge carriers of the first green light unit 62 and the equilibrium state of charge carriers of the first red light unit 63, improving the luminous efficiency of the first green light unit 62 and the luminous efficiency of the first red light unit 63, prolonging the service life of the first green light unit 62 and the service life of the first red light unit 63, and improving the smear problem in the low grayscale state of the display panel.

Specifically, the second-type charge generation layer 92 is a P-type charge generation layer 90.

In some embodiments of the present application, a hole mobility of the second-type charge generation layer 92 is greater than or equal to 10⁻² cm²/Vs, and the hole mobility enhancement material includes a metal or a metal dopant.

In some embodiments of the present application, the display panel further includes at least one of a first hole injection layer 30, a first hole transport layer 40, a first hole blocking layer 70, a first electron transport layer 80, a second hole transport layer 100, a second hole blocking layer 130, a second electron transport layer 140, a second electron injection layer 150, and a capping layer 170. The first hole injection layer 30 is disposed on one side of the first electrode layer 20 facing away from the substrate 10. The first hole transport layer 40 is disposed on one side of the first hole injection layer 30 facing away from the substrate 10. The first hole blocking layer 70 is disposed on one side of the first light-emitting layer 60 facing away from the substrate 10. The first electron transport layer 80 is disposed on one side of the first hole blocking layer 70 facing away from the substrate 10. The second hole transport layer 100 is disposed on one side of the charge generation layer 90 facing away from the substrate 10. The second hole blocking layer 130 is disposed on one side of the second light-emitting layer 120 facing away from the substrate 10. The second electron transport layer 140 is disposed on one side of the second hole blocking layer 130 facing away from the substrate 10. The second electron injection layer 150 is disposed on one side of the second electron transport layer 140 facing away from the substrate 10. The capping layer 170 is disposed on one side of the second electrode layer 160 facing away from the substrate 10.

In some embodiments of the present application, the fourth electron blocking part 111, the fifth electron blocking part 112, and the sixth electron blocking part 113 are spaced apart from each other.

In a second aspect, Embodiment 1 of the present application provides a display device. The display device includes a housing and a display panel according to any one of the above. The housing has an accommodation space, and the display panel is disposed in the accommodation space.

### Embodiment 2

FIG. 2 is a schematic structural diagram of a display panel provided in Embodiment 2 of the present application. Referring to FIG. 2, in a first aspect, Embodiment 2 of the present application provides a display panel. The display panel includes a substrate 10, a first electrode layer 20, a first electron blocking layer 50, a first light-emitting layer 60, a charge generation layer 90, a second light-emitting layer 120, and a second electrode layer 160. The first electrode layer 20 is provided on one side of the substrate 10. The first electron blocking layer 50 is provided on one side of the first electrode layer 20 is facing away from the substrate 10. The first light-emitting layer 60 is disposed on one side of the first electron blocking layer 50 facing away from the substrate 10. The charge generation layer 90 is disposed on one side of the first light-emitting layer 60 facing away from the substrate 10. The second light-emitting layer 120 is disposed on one side of the charge generation layer 90 facing away from the substrate 10. The second electrode layer 160 is disposed on one side of the second light-emitting layer 120 facing away from the substrate 10. The first light-emitting layer 60 includes a first blue light unit 61, a first green light unit 62, and a first red light unit 63. The first electron blocking layer 50 includes a first electron blocking part 51, a second electron blocking part 52, and a third electron blocking part 53. The first electron blocking part 51 corresponds to the first blue light unit 61, the second electron blocking part 52 corresponds to the first green light unit 62, and the third electron blocking part 53 corresponds to the first red light unit 63. In the first electron blocking layer 50, the first electron blocking part 51, the second electron blocking part 52, and the third electron blocking part 53 are arranged into an integrated structure.

It should be noted that a structure of the display panel provided in Embodiment 2 of the present application is similar to a structure of the display panel provided in Embodiment 1 of the present application, and the same parts will not be described again in the present application.

In some embodiments of the present application, the second light-emitting layer 120 further includes a second green light unit 122 and a second red light unit 123, and the second electron blocking layer 110 further includes a fifth electron blocking part 112 corresponding to the second green light unit 122 and a sixth electron blocking part 113 corresponding to the second red light unit 123. In the second electron blocking layer 110, the fourth electron blocking part 111, the fifth electron blocking part 112, and the sixth electron blocking part 113 are arranged into an integrated structure. The display panel further includes a third electron blocking layer 180 disposed between the second light-emitting layer 120 and the second electron blocking layer 110. The third electron blocking layer 180 includes a seventh electron blocking part 181 corresponding to the second green light unit 122 and an eighth electron blocking part 182 corresponding to the second red light unit 123. The seventh electron blocking part 181 and the eighth electron blocking part 181 are spaced apart from each other.

In the display panel provided by the embodiments of the present application, in the second electron blocking layer 110, since the fourth electron blocking part 111, the fifth electron blocking part 112, and the sixth electron blocking part 113 are arranged into the integrated structure, and the third electron blocking layer 180 is disposed between the second light-emitting layer 120 and the second electron blocking layer 110, therefore, the second electron blocking layer 110 including the fourth electron blocking part 111, the fifth electron blocking part 112, and the sixth electron blocking part 113 can serve as a carrier layer, and the seventh electron blocking part 181 and the eighth electron blocking part 188 can be prepared on the carrier layer, so that the seventh electron blocking part 181 and the eighth electron blocking part 188 can be made as thin as possible when the second electron blocking part 52 and the third electron blocking part 53 are thinned, thereby reducing the manufacturing costs.

In some embodiments of the present application, a surface of the second blue light unit 121 close to the substrate 10 is in direct contact with a surface of the second electron blocking layer 110 facing away from the substrate 10.

In a second aspect, Embodiment 2 of the present application provides a display device. The display device includes a housing and a display panel according to any one of the above. The housing has an accommodation space, and the display panel is disposed in the accommodation space.

To sum up, the present application provides a display panel and a display device. The display panel includes a substrate, a first electrode layer, a first electron blocking layer, a first light-emitting layer, a charge generation layer, a second light-emitting layer, a second light-emitting layer, and a second electrode layer. The first electrode layer is provided on one side of the substrate, the first electron blocking layer is provided on one side of the first electrode layer facing away from the substrate, the first light-emitting layer is provided on one side of the first electron blocking layer facing away from the substrate, the charge generation layer is disposed on one side of the first light-emitting layer facing away from the substrate, the second light-emitting layer is disposed on one side of the charge generation layer facing away from the substrate, and the second electrode layer is disposed on one side of the second light-emitting layer facing away from the substrate. The first light-emitting layer includes a first blue light unit, a first green light unit, and a first red light unit. The first electron blocking layer includes a first electron blocking part, a second electron blocking part, and a third electron blocking part. The first electron blocking part corresponds to the first blue light unit, the second electron blocking part corresponds to the first green light unit, and the third electron blocking part corresponds to the first red light unit. In the first electron blocking layer, the first electron blocking part, the second electron blocking part, and the third electron blocking part are arranged into an integrated structure. The display panel provided by the present application can effectively solve the technical problems of complex structure and high manufacturing costs of display panels.

The display panel and display device provided by the embodiments of the present application has been introduced in detail above. Specific examples are used in this paper to illustrate the principles and implementation methods of the present application. The description of the above embodiments is only used to help understand the methods and core ideas of the present application. At the same time, for those skilled in the art, there will be changes in the specific implementation and application scope based on the ideas of the present application. In summary, the content of this description should not be understood as a limitation of the present application.

## Claims

1. A display panel, comprising:
a substrate;
a first electrode layer, disposed on one side of the substrate;
a first electron blocking layer, disposed on one side of the first electrode layer facing away from the substrate;
a first light-emitting layer, disposed on one side of the first electron blocking layer facing away from the substrate;
a charge generation layer, disposed on one side of the first light-emitting layer facing away from the substrate;
a second light-emitting layer, disposed on one side of the charge generation layer facing away from the substrate; and
a second electrode layer, disposed on one side of the second light-emitting layer facing away from the substrate,
wherein the first light-emitting layer comprises a first blue light unit, a first green light unit, and a first red light unit, and the first electron blocking layer comprises a first electron blocking part corresponding to the first blue light unit, a second electron blocking part corresponding to the first green light unit, and a third electron blocking part corresponding to the first red light unit; and
in the first electron blocking layer, the first electron blocking part, the second electron blocking part, and third electron blocking part are arranged into an integrated structure.

2. The display panel according to claim 1, wherein the second light-emitting layer comprises a second blue light unit, the display panel further comprises a second electron blocking layer, the second electron blocking layer comprises a fourth electron blocking part corresponding to the second blue light unit, and the fourth electron blocking part is made of a same material as the first electron blocking part.

3. The display panel according to claim 2, wherein both the first blue light unit and the second blue light unit comprises fluorescent materials.

4. The display panel according to claim 2, wherein the second light-emitting layer further comprises a second green light unit, the second electron blocking layer comprises a fifth electron blocking part corresponding to the second green light unit, a HOMO energy level of the second electron blocking part is greater than a HOMO energy level of the fifth electron blocking part, and a LUMO energy level of the second electron blocking part is less than a LUMO energy level of the fifth electron blocking part.

5. The display panel according to claim 4, wherein a thickness of the second electron blocking part is same with a thickness of the first electron blocking part, and a thickness of the fifth electron blocking part is 5-7 times a thickness of the fourth electron blocking part.

6. The display panel according to claim 5, wherein the second light-emitting layer further comprises a second red light unit, the second electron blocking layer comprises a sixth electron blocking part corresponding to the second red light unit, a HOMO energy level of the third electron blocking part is greater than a HOMO energy level of the sixth electron blocking part, and a LUMO energy level of the third electron blocking part is less than a LUMO energy level of the sixth electron blocking part.

7. The display panel according to claim 6, wherein a thickness of the third electron blocking part is same with a thickness of the first electron blocking part, and a thickness of the sixth electron blocking part is 15-17 times a thickness of the fourth electron blocking part.

8. The display panel according to claim 7, wherein the charge generation layer comprises a first-type charge generation layer and a second-type charge generation layer, and the second-type charge generation layer is disposed on one side of the first-type charge generation layer facing away from the first light-emitting layer;
the first-type charge generation layer comprises an electron mobility enhancement material, and a doping ratio of the electron mobility enhancement material ranges from 5% to 15%; and the second-type charge generation layer comprises a hole mobility enhancement material, and a doping ratio of the hole mobility enhancement material ranges from 1% to 10%.

9. The display panel according to claim 6, wherein the fourth electron blocking part, the fifth electron blocking part, and the sixth electron blocking part are spaced apart from each other.

10. The display panel according to claim 2, wherein the second light-emitting layer further comprises a second green light unit and a second red light unit, the second electron blocking layer further comprises a fifth electron blocking part corresponding to the second green light unit and a sixth electron blocking part corresponding to the second red light unit; and in the second electron blocking layer, the fourth electron blocking part, the fifth electron blocking part, and the sixth electron blocking part are arranged into an integrated structure;
the display panel further comprises a third electron blocking layer disposed between the second light-emitting layer and the second electron blocking layer, the third electron blocking layer comprises a seventh electron blocking part corresponding to the second green light unit and an eighth electron blocking part corresponding to the second red light unit, and the seventh electron blocking part and the eighth electron blocking part are spaced apart from each other.

11. The display panel according to claim 10, wherein a surface of the second blue light unit close to the substrate is in direct contact with a surface of the second electron blocking layer facing away from the substrate.

12. A display device, comprising a housing and a display panel, wherein the housing has an accommodation space, the display panel is disposed in the accommodating space, and the display panel comprises:
a substrate;
a first electrode layer, disposed on one side of the substrate;
a first electron blocking layer, disposed on one side of the first electrode layer facing away from the substrate;
a first light-emitting layer, disposed on one side of the first electron blocking layer facing away from the substrate;
a charge generation layer, disposed on one side of the first light-emitting layer facing away from the substrate;
a second light-emitting layer, disposed on one side of the charge generation layer facing away from the substrate; and
a second electrode layer, disposed on one side of the second light-emitting layer facing away from the substrate,
wherein the first light-emitting layer comprises a first blue light unit, a first green light unit, and a first red light unit, and the first electron blocking layer comprises a first electron blocking part corresponding to the first blue light unit, a second electron blocking part corresponding to the first green light unit, and a third electron blocking part corresponding to the first red light unit; and in the first electron blocking layer, the first electron blocking part, the second electron blocking part, and third electron blocking part are arranged into an integrated structure.

13. The display device according to claim 12, wherein the second light-emitting layer comprises a second blue light unit, the display panel further comprises a second electron blocking layer, the second electron blocking layer comprises a fourth electron blocking part corresponding to the second blue light unit, and the fourth electron blocking part is made of a same material as the first electron blocking part.

14. The display device according to claim 13, wherein both the first blue light unit and the second blue light unit comprises fluorescent materials.

15. The display device according to claim 13, wherein the second light-emitting layer further comprises a second green light unit, the second electron blocking layer comprises a fifth electron blocking part corresponding to the second green light unit, a HOMO energy level of the second electron blocking part is greater than a HOMO energy level of the fifth electron blocking part, and a LUMO energy level of the second electron blocking part is less than a LUMO energy level of the fifth electron blocking part.

16. The display device according to claim 15, wherein a thickness of the second electron blocking part is same with a thickness of the first electron blocking part, and a thickness of the fifth electron blocking part is 5-7 times a thickness of the fourth electron blocking part.

17. The display device according to claim 16, wherein the second light-emitting layer further comprises a second red light unit, the second electron blocking layer comprises a sixth electron blocking part corresponding to the second red light unit, a HOMO energy level of the third electron blocking part is greater than a HOMO energy level of the sixth electron blocking part, and a LUMO energy level of the third electron blocking part is less than a LUMO energy level of the sixth electron blocking part.

18. The display device according to claim 17, wherein a thickness of the third electron blocking part is same with a thickness of the first electron blocking part, and a thickness of the sixth electron blocking part is 15-17 times a thickness of the fourth electron blocking part.

19. The display device according to claim 18, wherein the charge generation layer comprises a first-type charge generation layer and a second-type charge generation layer, and the second-type charge generation layer is disposed on one side of the first-type charge generation layer facing away from the first light-emitting layer;
the first-type charge generation layer comprises an electron mobility enhancement material, and a doping ratio of the electron mobility enhancement material ranges from 5% to 15%; and the second-type charge generation layer comprises a hole mobility enhancement material, and a doping ratio of the hole mobility enhancement material ranges from 1% to 10%.

20. The display device according to claim 13, wherein the second light-emitting layer further comprises a second green light unit and a second red light unit, the second electron blocking layer further comprises a fifth electron blocking part corresponding to the second green light unit and a sixth electron blocking part corresponding to the second red light unit; and in the second electron blocking layer, the fourth electron blocking part, the fifth electron blocking part, and the sixth electron blocking part are arranged into an integrated structure;
the display panel further comprises a third electron blocking layer disposed between the second light-emitting layer and the second electron blocking layer, the third electron blocking layer comprises a seventh electron blocking part corresponding to the second green light unit and an eighth electron blocking part corresponding to the second red light unit, and the seventh electron blocking part and the eighth electron blocking part are spaced apart from each other.
